Europäisches Patentamt

European Patent Office

Office européen des brevets

(11) Veröffentlichungsnummer: 0 164 448
A1

# (12) EUROPÄISCHE PATENTANMELDUNG

(21) Anmeldenummer: 84115576.5

(22) Anmeldetag: 17.12.84

(51) Int. Cl.⁴: H 03 D 1/00
H 04 L 27/06

(30) Priorität: 15.05.84 DE 3418049

(43) Veröffentlichungstag der Anmeldung:
18.12.85 Patentblatt 85/51

(84) Benannte Vertragsstaaten:
AT BE CH DE FR GB IT LI LU NL SE

(71) Anmelder: Siemens Aktiengesellschaft
Berlin und München Wittelsbacherplatz 2
D-8000 München 2(DE)

(72) Erfinder: Frühauf, Waldemar, Dr.
Clausewitzstrasse 34
D-8500 Nürnberg(DE)

(54) Demodulator für amplitudenmodulierte Trägerfrequenzschwingungen.

(57) Dem erfindungsgemäßen Demodulator werden amplitudenmodulierte Trägerfrequenzschwingungen zugeführt, deren Spitzenwert empfangsseitig durch einen Regler (10) konstant gehalten wird. Dabei werden die Trägerfrequenzschwingungen über einen Kondensator (2) zwei Eingängen eines NOR-Gatters (3) zugeführt. Beide Eingänge des NOR-Gatters (3) sind über einen Widerstand (4) mit dessen Ausgang verbunden. Der Ausgang des NOR-Gatters (3) ist mit einem Inverter (9) verbunden, an dessen Ausgang die ausgewerteten Trägerfrequenzschwingungen abgegriffen werden. Dabei wird die Tatsache ausgenutzt, daß bei C-MOS-Schaltkreisen die einzelnen Gatter unterschiedliche Schwellwerte haben. Die zur Demodulation erforderlichen Komparatorfunktionen können daher mit geringem Aufwand unter Verwendung von Gattern eines C-MOS-Schaltkreises realisiert werden.

FIG 5

EP 0 164 448 A1

Croydon Printing Company Ltd.

SIEMENS AKTIENGESELLSCHAFT          Unser Zeichen
Berlin und München                 VPA **84** P **3173** **E**

Demodulator für amplitudenmodulierte
Trägerfrequenzschwingungen

Die Erfindung betrifft einen Demodulator für amplitudenmodulierte Trägerfrequenzschwingungen, deren Spitzenwert empfangsseitig durch einen Regler auf einem konstanten Wert gehalten wird.

In der DE-OS 32 15 081 ist ein System zur Übertragung von Informationstelegrammen in Form von Digitalsignalen beschrieben. Mit den Digitalsignalen wird dabei eine Trägerfrequenz moduliert, die beispielsweise über ein Stromnetz übertragen werden kann. Jedes Informationstelegramm wird damit durch eine codierte Folge von Trägerfrequenzimpulsen gebildet. Die Auswertung der codierten Signale erfolgt am einfachsten mit hochintegrierten C-MOS-Schaltkreisen, wobei sich der Einsatz von Gate-Arrays anbietet. Derartige Schaltkreise weisen nur digitale Funktionselemente auf. Zur Demodulation der Digitalsignale sind jedoch analoge Funktionen notwendig. Die Verwendung von Analogbausteinen zusätzlich zum hochintegrierten C-MOS-Schaltkreis bedeutet einen erheblichen Aufwand.

Aufgabe der Erfindung ist es daher, einen Demodulator der eingangs genannten Art so auszuführen, daß seine Funktion weitgehend vom C-MOS-Schaltkreis mit übernommen werden kann.

Diese Aufgabe wird erfindungsgemäß dadurch gelöst, daß die Trägerfrequenzschwingungen über einen Kondensator zwei Eingängen eines NOR-Gatters zugeführt sind, daß beide Eingänge des NOR-Gatters über einen Widerstand mit

Sid 2 Sir / 11.05.1984

dessen Ausgang verbunden sind, daß der Ausgang des NOR-Gatters mit einem Inverter verbunden ist und daß am Ausgang des Inverters die ausgewerteten Trägerfrequenzschwingungen abgegriffen werden.

Dabei stellt das NOR-Gatter eine symmetrierende Verstärkerstufe dar, die den Trägerfrequenzschwingungen ein definiertes Mittenpotential gibt. Das Mittenpotential ist höher als die halbe Amplitude der Trägerfrequenzschwingungen. Damit bleibt das gesamte Trägerfrequenzsignal stets positiv, wie es für die Verarbeitung im C-MOS-Schaltkreis erforderlich ist. Der dem NOR-Gatter nachgeschaltete Inverter wirkt als Komparator, der ausgangsseitig nur dann ein Signal abgibt, wenn sein Eingangssignal einen festgelegten Pegel überschreitet.

Vorteilhafterweise ist der Ausgang des NOR-Gatters mit zwei Eingängen eines NAND-Gatters verbunden, dessen Ausgang über einen Widerstand und einen Kondensator mit einem Bezugspotential verbunden ist, wobei die am Kondensator anstehende Regelabweichung des Spitzenwertes der Trägerfrequenzschwingungen dem Regler zugeführt wird. Damit kann mit einem Gatter des C-MOS-Schaltkreises ein weiterer Spannungsvergleich durchgeführt werden, wobei durch dieses Gatter die Soll-Amplitude für die Trägerfrequenzschwingungen vorgegeben wird.

Dabei wird vorteilhafterweise zwischen NAND-Gatter und Widerstand ein P-MOS-Transistor geschaltet, dessen Gate mit dem Ausgang des NAND-Gatters verbunden ist und dessen Drain-Source-Strecke zwischen einer Versorgungsspannung und dem Widerstand liegt. Mit diesem P-MOS-Transistor wird das Ausgangssignal des NAND-Gatters verstärkt und außerdem invertiert, was im allgemeinen zur Funktion des Reglers erforderlich ist, wenn das Stellglied zur Amplitudendämpfung eine positive Spannung benötigt.

Der Ausgang des NOR-Gatters kann mit beiden Eingängen eines weiteren NOR-Gatters verbunden sein, an dessen Ausgang die Trägerfrequenzschwingungen als Rechtecksignale abgegriffen werden. Damit können auch Trägerfrequenzsignale, die zusätzlich zur Amplitudenmodulation noch eine Frequenzmodulation enthalten, ausgewertet werden.

In einer alternativen Ausführungsform können die Trägerfrequenzschwingungen über einen Kondensator zwei Eingängen eines NAND-Gatters zugeführt sein, wobei beide Eingänge des NAND-Gatters über einen Widerstand mit dessen Ausgang verbunden sind, wobei der Ausgang des NAND-Gatters mit einem Inverter verbunden ist und wobei am Ausgang des Inverters die ausgewerteten Trägerfrequenzschwingungen abgegriffen werden. Bei einem derartigen Demodulator erfolgt ebenfalls eine Symmetrierung der Trägerfrequenzschwingungen auf ein definiertes Mittenpotential und ein Vergleich mit einem Schwellwert durch den als Komparator wirkenden Inverter. Gegenüber der vorgenannten Ausführung ist lediglich das Ausgangssignal invertiert.

Entsprechend wird zur Bestimmung des Spitzenwerts der Trägerfrequenzschwingungen der Ausgang des NAND-Gatters zweckmäßigerweise mit zwei Eingängen eines NOR-Gatters verbunden, dessen Ausgang über einen Widerstand und einen Kondensator mit einem Bezugspotential verbunden ist, wobei die am Kondensator anstehende Regelabweichung der Amplitude des Digitalsignals dem Regler zugeführt wird.

Zur Auswertung der Frequenz der Trägerfrequenzschwingungen wird vorteilhafterweise der Ausgang des NAND-Gatters mit beiden Eingängen eines weiteres NAND-Gatters verbunden, an dessen Ausgang die Trägerfrequenzschwingungen als Rechtecksignale abgegriffen werden.

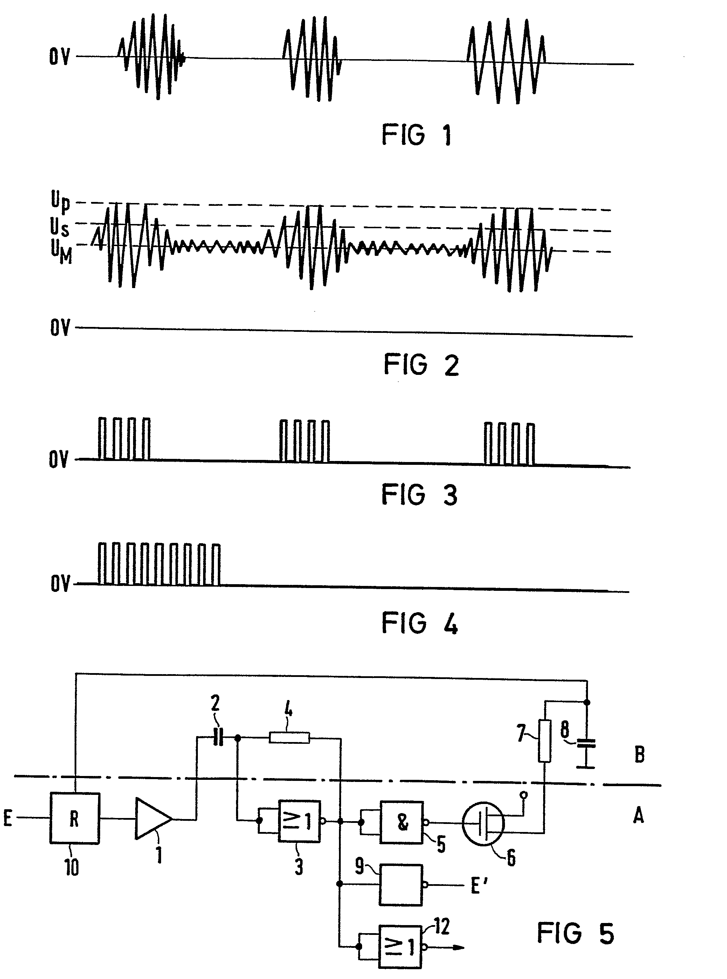

Ein Ausführungsbeispiel der Erfindung wird nachfolgend anhand der Figuren 1 bis 9 näher erläutert.

Fig. 1 zeigt beispielhaft ein aus einzelnen Trägerfrequenzsignalen zusammengesetztes Informationstelegramm. Jedes Trägerfrequenzsignal besteht dabei aus einer Vielzahl von Schwingungen einer Trägerfrequenz. Aufgabe des Demodulators ist es u.a., dem über einen Kondensator potentialfrei übertragenen Signal ein definiertes Mittenpotential zu geben. Da C-MOS-Schaltkreise nur positive Spannungen verarbeiten können, muß das Mittenpotential $U_M$ so liegen, daß das Signal stets positiv bleibt. In Fig. 2 ist das entsprechend symmetrierte Signal dargestellt. Ferner muß das Signal für die weitere Auswertung eine konstante Spitzenspannung $U_p$ aufweisen. Schließlich muß es mit einem Schwellwert $U_S$ verglichen werden, bei dessen Überschreitung es als "Eins"-Signal ausgewertet wird. Dabei soll der Schwellwert $U_S$ zur Erreichung eines optimalen Störabstands etwa in der Mitte zwischen der Spitzenspannung $U_P$ und dem Mittenpotential $U_M$ liegen. Die erwähnten Funktionen des Demodulators setzen an sich analoge Bausteine, im wesentlichen Komparatoren, voraus.

In Fig. 5 ist eine Schaltung dargestellt, bei der die erwähnten analogen Funktionen mit Hilfe von Gattern aufgebaut und daher weitestgehend mit einem C-MOS-Schaltkreis realisiert werden können. Zusätzlich zum C-MOS-Schaltkreis sind lediglich zwei Widerstände und zwei Kondensatoren erforderlich. In Fig. 5 sind die im C-MOS-Schaltkreis enthaltenen Elemente in einem Bereich A, die anderen Elemente in einem Bereich B eingezeichnet. Das Eingangssignal E wird über einen Regler 10, einen Vorverstärker 1 und einen Kondensator 2 den beiden Eingängen eines NOR-Gatters 3 zugeführt. Die beiden Eingänge des NOR-Gatters 3 sind über einen Widerstand 4 mit
seinem Ausgang verbunden. Der Ausgang des NOR-Gatters 3
ist außerdem mit einem Inverter 9 verbunden, an dessen
Ausgang das demodulierte Signal E' ansteht. Der Ausgang
des NOR-Gatters 3 ist ferner mit den beiden Eingängen
eines UND-Gatters 5 verbunden, dem ausgangsseitig das
Gate eines P-MOS-Transistors 6 nachgeschaltet ist. Der
Drainanschluß des P-MOS-Transistors 6 liegt an einer
Versorgungsspannung, der Sourceanschluß über einen Widerstand 7 und einen Kondensator 8 am Bezugspotential.
Der Verbindungspunkt von Widerstand 7 und Kondensator 8
ist mit einem Eingang des Reglers 10 verbunden. Dabei
stellen alle dargestellten Bauelemente mit Ausnahme der
Kondensatoren 2 und 8 und der Widerstände 4 und 7 Bestandteile eines C-MOS-Schaltkreises dar.

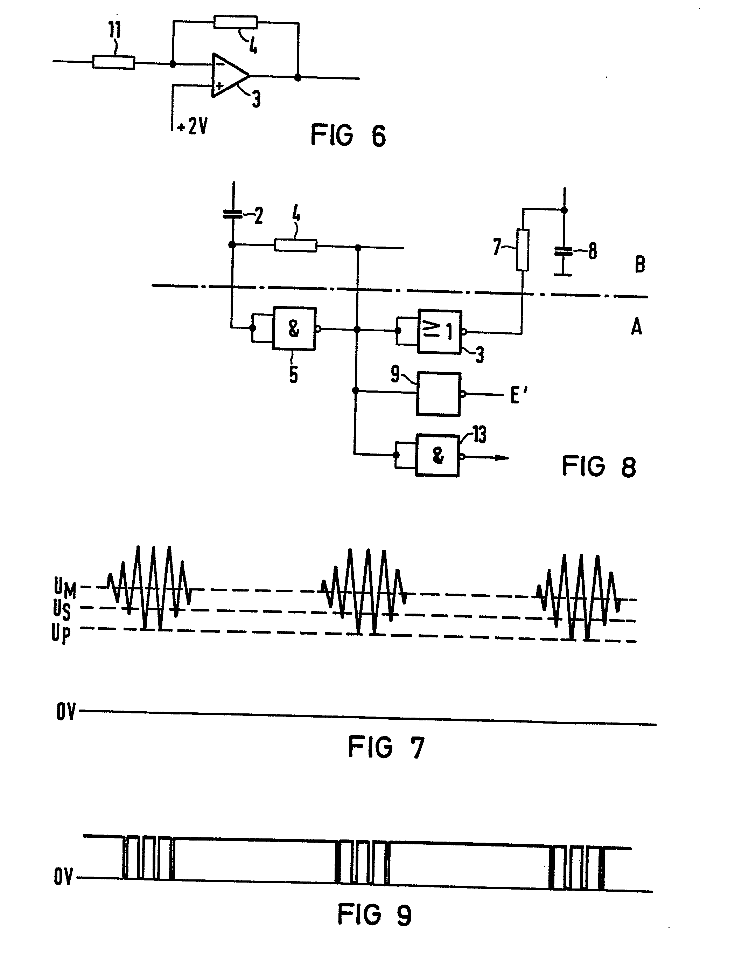

Bei der dargestellten Schaltung wird mit dem über einen
Widerstand 4 rückgekoppelten NOR-Gatter 3 dem Signal ein
definiertes Mittenpotential von 2 V aufgeprägt. Zur
Erläuterung ist in Fig. 6 ein Ersatzschaltbild für das
rückgekoppelte NOR-Gatter 3 dargestellt. Dieses verhält
sich wie ein rückgekoppelter Operationsverstärker, dem
am invertierenden Eingang ein Signal zugeführt wird.
Das NOR-Gatter 3 weist ferner eine Schwellspannung auf,
die bei C-MOS-Gattern mit zwei Eingängen typischerweise
bei 2 V liegt. Dies wirkt so, als ob der nicht invertierende Eingang eines Operationsverstärkers mit einer
Spannung von 2 V beschaltet wäre. Der im Ersatzschaltbild dargestellte Widerstand 11 kann durch im C-MOS-
Schaltkreis inhärente Widerstände gebildet werden.

Nachdem das Eingangssignal also mit dem rückgekoppelten
NOR-Gatter 3 auf ein Mittenpotential $U_M$ von ca. 2 V symmetriert ist, wird es den beiden Eingängen eines NAND-
Gatters 5 zugeführt. NAND-Gatter mit zwei Eingängen weisen in C-MOS-Technik typischerweise eine Schwellspannung von 3 Volt auf. Das NAND-Gatter 5 erzeugt also zusammen mit dem nachgeschalteten P-MOS-Transistor 6, dem Widerstand 7 und dem Kondensator 8 einen Schwellwert $U_p$ von ca. 3 Volt für den Spitzenwert der Signalspannung. Am Kondensator 8 steht daher eine Regelabweichung für die Spitzenwertregelung an, die dem Regler 10 zugeführt wird.

Der weitere, in Fig. 2 mit $U_S$ bezeichnete Schwellwert zur Auswertung des Signals wird schließlich mit dem Inverter 9 realisiert. Inverter weisen in C-MOS-Technik typischerweise eine Schwellspannung von 2,5 Volt auf. Am Ausgang des Inverters 9 steht daher nur dann ein Signal an, wenn das Eingangssignal diesen Pegel überschreitet. Die Schwellspannung $U_S$ von 2,5 Volt liegt - wie gewünscht - in der Mitte zwischen dem Mittenpotential $U_M$ von 2 Volt und dem Schwellwert $U_p$ von 3 Volt für die Spitzenspannung.

Wenn die Trägerfrequenzschwingungen außer einer Amplitudenmodulation auch noch eine Frequenzmodulation aufweisen, ist es zur Demodulation zweckmäßig, wenn man die Trägerfrequenzschwingungen als Rechtecksignale zur Verfügung hat. Dies wird erreicht, wenn man entsprechend Fig. 5 dem NOR-Gatter 3 ein weiteres NOR-Gatter 12 nachschaltet. Dessen Schwellwert ist nahezu identisch mit dem Schwellwert $U_M$ des NOR-Gatters 3. Die mit kleiner Amplitude stets vorhandenen Trägerfrequenzschwingungen werden daher mit dem NOR-Gatter 12 in die in Fig. 4 dargestellten Rechteckschwingungen umgeformt. Damit kann zur Demodulation beispielsweise ein PLL-Kreis gesteuert werden.

Mit der erfindungsgemäßen Schaltung können also die an sich analogen Funktionen eines Demodulators mit den Gattern eines C-MOS-Schaltkreises realisiert werden.

Dabei wird die Tatsache ausgenützt, daß die Gatter unterschiedliche Schwellwerte haben. Die typischen Werte liegen für NAND-Gatter mit zwei Eingängen bei 3 V, für NOR-Gatter mit zwei Eingängen bei 2 V und für Inverter bei 2,5 V. Dies ist beispielsweise der Druckschrift "C MOS Design Manual" der Firma Interdesign (Ferranti), Seiten 431, 432 entnehmbar. Diese Schwellwerte unterliegen zwar für unterschiedliche Schaltkreise starken Variationen, ihr Verhältnis zueinander ist jedoch innerhalb eines einzigen Schaltkreises weitgehend konstant. Für die Demodulatorfunktion kommt es aber weniger auf die Absolutwerte der Schwellspannungen, sondern in erster Linie auf ihre Relation zueinander an.

Der erfindungsgemäße Gedanke kann auf ähnliche Weise realisiert werden, wenn man entsprechend Fig. 7 die Schwellwerte $U_M$ für das Mittenpotential und $U_P$ für die Spitzenspannung vertauscht. $U_P$ liegt dann z. B. bei 2 V, $U_M$ bei 3 V und der Schwellwert $U_S$ zur Auswertung des Signals bleibt bei 2,5 V, also in der Mitte zwischen $U_M$ und $U_P$. Eine entsprechende Schaltung ist in Fig. 8 dargestellt. Dabei sind gegenüber der Schaltung nach Fig. 5 NOR-Gatter 3 und NAND-Gatter 5 vertauscht. Das Eingangssignal wird also dem über einen Widerstand 4 rückgekoppelten NAND-Gatter 5 zugeführt, dem ausgangsseitig die beiden Eingänge des NOR-Gatters 3 nachgeschaltet sind. Ebenso ist dem NAND-Gatter 5 der Inverter 9 nachgeschaltet. Gegenüber der Schaltung nach Fig. 5 sind lediglich die Ausgangssignale des Inverters 9 und des NOR-Gatters 3 invertiert. Wenn die Spannung der Trägerfrequenzschwingungen größer als 0,5 V wird, so wird der Schwellwert $U_S$ unterschritten. Die Ausgangsspannung des Inverters 9 geht damit, wie in Fig. 9 dargestellt, auf "Null", während sie ansonsten bei "Eins" liegt. Ebenso geht die Ausgangsspannung des NOR-Gatters 3 auf Null, wenn der Spitzenwert der Spannung der Trägerfrequenzschwingungen den Sollwert überschreitet und damit unter $U_p$ liegt. Wenn der Regler 10 zur Amplitudendämpfung eine positive Spannung benötigt, ist daher nach dem NOR-Gatter keine Inversion mehr nötig. Zur Ableitung von mit den Trägerfrequenzschwingungen frequenzgleichen Rechteckschwingungen kann den NAND-Gatter 5 ein zweites NAND-Gatter 13 nachgeschaltet werden. Wie bei der Schaltungsanordnung bei der Fig. 5 wird damit eine Schwellspannung gebildet, die nahezu identisch mit dem Mittenpotential $U_M$ ist, so daß auch Trägerfrequenzschwingungen kleiner Amplitude in Rechteckimpulse umgewandelt werden.

7 Patentansprüche
9 Figuren

Patentansprüche

1. Demodulator für amplitudenmodulierte Trägerfrequenzschwingungen, deren Spitzenwert empfangsseitig durch einen Regler (10) auf einem konstanten Wert gehalten wird,
d a d u r c h   g e k e n n z e i c h n e t ,   daß die
Trägerfrequenzschwingungen über einen Kondensator (2)
zwei Eingängen eines NOR-Gatters (3) zugeführt sind, daß
beide Eingänge des NOR-Gatters (3) über einen Widerstand
(4) mit dessen Ausgang verbunden sind, daß der Ausgang
des NOR-Gatters (3) mit einem Inverter (9) verbunden ist
und daß am Ausgang des Inverters (9) die ausgewerteten
Trägerfrequenzschwingungen abgegriffen werden.

2. Demodulator nach Anspruch 1,   d a d u r c h   g e -
k e n n z e i c h n e t ,   daß der Ausgang des NOR-Gatters (3) mit zwei Eingängen eines NAND-Gatters (5) verbunden ist, dessen Ausgang über einen Widerstand (7) und
einen Kondensator (8) mit einem Bezugspotential verbunden ist und daß die am Kondensator (8) anstehende Regelabweichung des Spitzenwerts der Trägerfrequenzschwingungen dem Regler (10) zugeführt wird.

3. Demodulator nach Anspruch 2,   d a d u r c h   g e -
k e n n z e i c h n e t ,   daß zwischen NAND-Gatter (5)
und Widerstand (7) ein P-MOS-Transistor (6) geschaltet
ist, dessen Gate mit dem Ausgang des NAND-Gatters (5)
verbunden ist und dessen Drain-Source-Strecke zwischen
einer Versorungsspannung und dem Widerstand (7) liegt.

4. Demodulator nach einem der Ansprüche 1 bis 3,   d a -
d u r c h   g e k e n n z e i c h n e t ,   daß der Ausgang des NOR-Gatters (3) mit beiden Eingängen eines weiteren NOR-Gatters (12) verbunden ist, an dessen Ausgang die Trägerfrequenzschwingungen als Rechtecksignale abgegriffen werden.

5. Demodulator für amplitudenmodulierte Trägerfrequenzschwingungen, deren Spitzenwert empfangsseitig durch einen Regler (10) auf einem kontanten Wert gehalten wird,
d a d u r c h   g e k e n n z e i c h n e t ,   daß die
Trägerfrequenzschwingungen über einen Kondensator (2)
zwei Eingängen eines NAND-Gatters (5) zugeführt sind, daß
beide Eingänge des NAND-Gatters (5) über einen Widerstand
(4) mit dessen Ausgang verbunden sind, daß der Ausgang
des NAND-Gatters (5) mit einem Inverter (9) verbunden ist
und daß am Ausgang des Inverters (9) die ausgewerteten
Trägerfrequenzschwingungen abgegriffen werden.

6. Demodulator nach Anspruch 5,   d a d u r c h   g e -
k e n n z e i c h n e t ,   daß der Ausgang des NAND-
Gatters (5) mit zwei Eingängen eines NOR-Gatters (3)
verbunden ist, dessen Ausgang über einen Widerstand (7)
und einen Kondensator (8) mit einem Bezugspotential verbunden ist und daß die am Kondensator (8) anstehende Regelabweichung der Amplitude des Digitalsignals dem Regler (10) zugeführt wird.

7. Demodulator nach Anspruch 5 oder 6,   d a d u r c h
g e k e n n z e i c h n e t ,   daß der Ausgang des NAND-
Gatters (5) mit beiden Eingängen eines weiteren NAND-Gatters (13) verbunden ist, an dessen Ausgang die Trägerfrequenzschwingungen als Rechtecksignale abgegriffen werden.

0164448

FIG 1

FIG 2

FIG 3

FIG 4

FIG 5

2/2

84 P 3173

0164448

FIG 6

FIG 8

FIG 7

FIG 9

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int Cl 4) |
|---|---|---|---|
| A | ELECTRONIC DESIGN, Band 21, Nr. 25, 6. Dezember 1973, Seiten 112-115; R.S. SCHAMIS: "Reduce system noise with CMOS circuits that provide compensating waveshaping and level detection. The circuits are simple and use low-cost ICs" * Insgesamt * | 1,5 | H 03 D 1/00 H 04 L 27/06 |
| A | US-A-4 229 668 (EBIHARA et al.) * Figur 8; Spalte 4, Zeile 57 - Spalte 5, Zeile 24 * | 1,5 | |
| A | EP-A-0 092 750 (SIEMENS) & DE - A - 3 215 081 (Kat. D) | | |

RECHERCHIERTE SACHGEBIETE (Int. Cl.4)

H 03 D

Der vorliegende Recherchenbericht wurde für alle Patentansprüche erstellt.

| Recherchenort DEN HAAG | Abschlußdatum der Recherche 27-08-1985 | Prüfer GYSEN L.A.D. |
|---|---|---|